# EUROPEAN PATENT APPLICATION

(11) **EP 4 746 208 A1**
(43) Date of publication of application: **20.05.2026**
(21) Application number: 24857783.5
(22) Date of filing: 12.04.2024
(51) Int. Cl.: H01R 13/03, H01R 13/24, H01R 12/71, H01R 13/648

(54) **ELECTRICALLY CONDUCTIVE ELASTIC CONNECTOR AND ELECTRONIC DEVICE**

(30) Priority: 29.08.2023 CN 202322359558 U
(71) Applicant: Huawei Technologies Co., Ltd., Shenzhen, Guangdong 518129 (CN)
(72) Inventor: QIAN, Yungui, Shenzhen, Guangdong 518129 (CN); GENG, Yonghong, Shenzhen, Guangdong 518129 (CN); ZHOU, Jianjun, Shenzhen, Guangdong 518129 (CN); XU, Zuxiang, Shenzhen, Guangdong 518129 (CN); YU, Zhigang, Shenzhen, Guangdong 518129 (CN)
(74) Representative: Pfenning, Meinig & Partner mbB
(86) International application number: PCT/CN2024/087370
(87) International publication number: WO 2025/044233

(57) **Abstract**

This application provides an electrically conductive elastic connector and an electronic device. The electrically conductive elastic connector includes a foam core. The foam core includes a porous foam body and an electrically conductive layer located on the porous foam body. Nanowires are attached to an interior and an outer surface of the porous foam body to form the electrically conductive layer. The electrically conductive elastic connector further includes a first electrically conductive adhesion layer, a second electrically conductive adhesion layer, a first electrically conductive film, and a second electrically conductive film. The first electrically conductive adhesion layer is located on a first surface of the foam core, and the second electrically conductive adhesion layer is located on a second surface of the foam core. The first electrically conductive film is stacked on the first electrically conductive adhesion layer, and the first electrically conductive film is configured to electrically connect to a first element. The second electrically conductive film is stacked on the second electrically conductive adhesion layer, and the second electrically conductive film is configured to electrically connect to a second element. A conductive elastomer with low pressure and low PIM can be formed by bonding a conductive film on a foam body attached with nanowires, achieving long-term stable low PIM performance.

## Description

### TECHNICAL FIELD

This application relates to the field of conductive connectors, and in particular, to an electrically conductive elastic connector and an electronic device.

### BACKGROUND

To improve working performance of an electronic device, reduce radio frequency interference between components, increase isolation between the components, and reduce electrostatic risks, the electronic device usually needs to be grounded, and the components in the electronic device also need to be grounded. For example, a camera module needs to be grounded to avoid interference from a radio frequency signal of an antenna. A display module also needs to be grounded, to prevent electromagnetic noise from affecting normal operation of the display module. Generally, the antenna, the display module, or the camera module is grounded through an electrically conductive elastic connector. The electrically conductive elastic connector has a compression resilience characteristic, and can generate certain pressure (rebound force) to securely connect a component. In addition, the electrically conductive elastic connector is conductive, and can implement electromagnetic shielding or electrical connection.

As functions of the electronic device are diversified, the components included in the electronic device are also diversified, a quantity of components increases, and space in the electronic device is very limited. Therefore, an electrically conductive elastic connector is required to implement electrical connection between different components or to ground different components.

### UTILITY MODEL DESCRIPTION

Embodiments of this application provide an electrically conductive elastic connector and an electronic device. The electrically conductive elastic connector has a low harmonic characteristic, a wide operating range, and excellent reliability, and can achieve long-term stable low harmonic performance.

According to a first aspect, an embodiment of this application provides an electrically conductive elastic connector, where the electrically conductive elastic connector is configured to connect a first element and a second element. The electrically conductive elastic connector includes a foam core. The foam core includes a porous foam body and an electrically conductive layer located on the porous foam body. The electrically conductive layer is an electrically conductive layer formed by attaching nanowires to an interior and an outer surface of the porous foam body. The electrically conductive layer of the nanowires in the interior and on the outer surface of the porous foam body is formed, so that a problem of ground impedance deterioration caused by breaking of the electrically conductive layer can be reduced or avoided, stable low impedance within a large compression range can be implemented, and generation of a high harmonic wave can be avoided. Because the nanowires are used as the electrically conductive layer, strength of the nanowires and a bonding force between the nanowires and the foam body are high, and a problem of unstable ground impedance caused by fall-off of the electrically conductive layer can also be reduced.

In addition, when the foam core formed on the porous foam body is compressed, pressure (or a rebound force) slowly increases, so that a compression range corresponding to a second region that is less than a pressure upper limit is wide. Therefore, a compression range of a third region of the electrically conductive elastic connector is wide. In other words, an operating range in which the electrically conductive elastic connector meets both an impedance requirement and a pressure requirement is wide.

The foam core has a first surface and a second surface that are disposed opposite to each other. The electrically conductive elastic connector further includes a first electrically conductive adhesion layer and a second electrically conductive adhesion layer. The first electrically conductive adhesion layer is located on the first surface of the foam core, and the second electrically conductive adhesion layer is located on the second surface of the foam core.

The electrically conductive elastic connector further includes a first electrically conductive film and a second electrically conductive film. The first electrically conductive film is stacked on the first electrically conductive adhesion layer, and the first electrically conductive film is configured to electrically connect to the first element. The second electrically conductive film is stacked on the second electrically conductive adhesion layer, and the second electrically conductive film is configured to electrically connect to the second element.

The first electrically conductive film is bonded to the first electrically conductive adhesion layer, to enhance strength of the first electrically conductive adhesion layer, improve continuity of the first electrically conductive adhesion layer in a pressure scenario, and reduce or avoid a phenomenon that the foam core falls off the first element because the first electrically conductive adhesion layer with a small thickness is cracked or broken (for example, broken into a granular shape) when the electrically conductive elastic connector is under pressure. Correspondingly, the second electrically conductive film may also enhance strength of the second electrically conductive adhesion layer, improve continuity of the second electrically conductive adhesion layer in a pressure scenario, and reduce or avoid a phenomenon that the foam core falls off the second element because the second electrically conductive adhesion layer is cracked or broken under pressure, to effectively improve bonding fastness between the electrically conductive elastic connector and the first element and between the electrically conductive elastic connector and the second element, and improve reliability of the electrically conductive elastic connector. A conductive elastomer with low pressure and low PIM can be formed by bonding a conductive film on a foam body attached with nanowires, and long-term stable low PIM performance can be achieved.

With reference to the first aspect, in a possible implementation, a thickness of the first electrically conductive film and a thickness of the second electrically conductive film are 0.01 mm to 0.1 mm, so that a good enhancement effect can be achieved on the adhesion layer, and a problem such as breaking of the adhesion layer in a pressure scenario is reduced.

With reference to the first aspect, in a possible implementation, the first electrically conductive film and the second electrically conductive film are conductive fabrics or copper foils.

With reference to the first aspect, in a possible implementation, a thickness of the first electrically conductive adhesion layer and a thickness of the second electrically conductive adhesion layer are 2 µm to 20 µm, so that the first electrically conductive film and the second electrically conductive film are well connected to the foam core.

With reference to the first aspect, in a possible implementation, the first electrically conductive adhesion layer and the second electrically conductive adhesion layer are electrically conductive silver paste. The first electrically conductive adhesion layer, the second electrically conductive adhesion layer, the foam core, the first electrically conductive film, and the second electrically conductive film form an overall structure. The electrically conductive silver paste ensures good bonding between the electrically conductive silver paste and the electrically conductive layer of the foam core, and ensures conductive performance between the first electrically conductive film and the foam core and between the second electrically conductive film and the foam core.

With reference to the first aspect, in a possible implementation, the porous foam body is a low-density porous foam body whose density is less than 200 kg/m³. The low-density porous foam body can achieve 85% deformable amount, which significantly improves performance of the electrically conductive elastic connector.

With reference to the first aspect, in a possible implementation, the porous foam body has an inner hole and an outer hole, and a plurality of electrically conductive layers are attached to a hole wall of the inner hole and a hole wall of the outer hole. The inner hole is located at the interior of the porous foam body, and the outer hole is located on the outer surface of the foam body structure. The inner hole may be disposed to support the foam core. In addition, the outer hole is disposed, and the plurality of electrically conductive layers may be disposed on the hole wall of the outer hole, to ensure conductive performance of the outer surface of the foam core, and implement conduction of the first electrically conductive film and the second electrically conductive film.

With reference to the first aspect, in a possible implementation, the inner hole includes at least one of a closed hole and an open hole. The structure of the electrically conductive elastic connector includes both an open hole and a closed hole. In addition to rigidity and stability, a position or a region of the open hole is adjusted, so that the electrically conductive elastic connector may also have a soft and bendable characteristic.

With reference to the first aspect, in a possible implementation, a diameter of a hole of the porous foam body is 30 µm to 500 µm. In this way, compressible space and a rebound force of the porous foam body can meet a requirement of the operating range after the nanowire is attached to the hole wall.

With reference to the first aspect, in a possible implementation, a diameter of the nanowire is 10 nm to 50 nm. In this way, the nanowire can be more firmly coated on the hole wall of the inner hole, to avoid generation of high harmonics caused by fall-off of the nanowires under pressure. In addition, low ground impedance may be obtained by setting a diameter range from 10 nm to 50 nm.

With reference to the first aspect, in a possible implementation, a ratio of a length of the nanowire to a diameter of the nanowire ranges from 1000: 1 to 5000: 1 The nanowire may be prevented from being broken when the electrically conductive elastic connector is under pressure, so that the nanowire has rigidity and stability.

With reference to the first aspect, in a possible implementation, the nanowire is at least one of nano-silver, nano-copper, a carbon nanowire, and nano-gold.

With reference to the first aspect, in a possible implementation, the porous foam body is of a three-dimensional mesh structure, and the mesh structure is attached with a plurality of electrically conductive layers. The electrically conductive layer is a nanowire layer of a multi-layer structure, can implement high conductive performance, and has a high bonding force with the porous foam body, so that conductivity is improved and a risk such as a short circuit caused by a problem such as a breaking or fall-off of the electrically conductive layer is avoided.

According to a second aspect, an embodiment of this application provides an electronic device, where the electronic device includes a first element, a second element, and the electrically conductive elastic connector according to any one of the foregoing implementations.

The first electrically conductive film of the electrically conductive elastic connector is electrically connected to the first element, and the second electrically conductive film of the electrically conductive elastic connector is electrically connected to the second element.

With reference to the second aspect, in a possible implementation, the electronic device further includes a conductive adhesive, the conductive adhesive is disposed between the first electrically conductive film and the first element, and the conductive adhesive is disposed between the second electrically conductive film and the second element.

With reference to the second aspect, in a possible implementation, the first element is a middle frame, and the second element is at least one of an antenna bracket, a display module, a shielding cover, or a camera module.

### BRIEF DESCRIPTION OF DRAWINGS

FIG. 1 is a diagram of a hardware structure of an electronic device according to an embodiment of this application;
FIG. 2 is a connection diagram of an electrically conductive elastic connector according to an embodiment of this application;
FIG. 3A is a diagram of an electrically conductive elastic connector according to an embodiment of this application;
FIG. 3B is a curve diagram of a relationship between a compression amount and impedance and a relationship between the compression amount and pressure of an electrically conductive elastic connector according to an embodiment of this application;
FIG. 4 is a cross-sectional view of an FOF foam;
FIG. 5 is a cross-sectional view of an electrically conductive elastic connector according to an embodiment of this application; and
FIG. 6 is an electron microscope photo of an electrically conductive layer on a porous foam body in an electrically conductive elastic connector according to an embodiment of this application.

### DESCRIPTION OF EMBODIMENTS

To make objectives, technical solutions, and advantages of this application clearer, the following further describes this application in detail with reference to accompanying drawings.

The following describes the technical solutions in embodiments of this application with reference to the accompanying drawings in embodiments of this application. In the descriptions of embodiments of this application, "/" means "or" unless otherwise specified. For example, A/B may represent A or B. In this specification, "and/or" describes only an association relationship for describing associated objects and represents that three relationships may exist. For example, A and/or B may represent the following three cases: Only A exists, both A and B exist, and only B exists. In addition, in the descriptions of embodiments of this application, "a plurality of" means two or more.

The terms "first" and "second" mentioned below are merely intended for a purpose of description, and shall not be understood as an indication or implication of relative importance or implicit indication of the number of indicated technical features. Therefore, a feature limited by "first" or "second" may explicitly or implicitly include one or more features. In the description of embodiments, "a plurality of" means two or more unless otherwise specified.

Terms used in the description of the present invention in this specification are merely intended to describe specific embodiments, but are not intended to limit the present invention.

In addition, in this application, position terms such as "upper", and "lower", "front", and "rear" are defined relative to an illustrative position of a component in the accompanying drawings. It should be understood that these direction terms are relative concepts and are used for relative description and clarification, and may vary accordingly depending on a position change in which components are placed in the accompanying drawings.

It should be noted that the "electrical connection" in embodiments of this application should be understood in a broad sense, and may include a physical direct connection, or may include a coupled connection through a capacitor, a conductive fabric, or a conductive adhesive (or another material), or may include a combination of a coupled connection and a physical direct connection.

It should be further noted that shape descriptions such as "rectangle" and "circle" in embodiments of this application may include an approximate shape. Considering an actual processing error, the approximate shape also falls within the scope of embodiments of this application.

This application relates to an electrically conductive elastic connector, an electronic device, and a method for preparing an electrically conductive elastic connector. The following briefly describes concepts involved in this application.

A foam body is a material obtained by foaming and forming plastic particles, silicone particles, or rubber particles. The foam body includes but is not limited to polyurethane (polyurethane, PU for short) foam, silicone foam, polyethylene (polyethylene, PE for short) foam, polypropylene (polypropylene, PP for short) foam, styrene-butadiene rubber foam, acrylate foam, vinyl acetate foam, vinylidene chloride foam, butyronitrile foam, silicone foam, acrylamide foam, natural rubber foam, polyvinyl chloride foam, polysulfide rubber foam, styrene-acrylate copolymer foam, vinyl acetate-acrylate copolymer foam, silicone-acrylate copolymer foam, and modified silicone-acrylate copolymer foam.

Foaming is a process of making a plastic, a silica gel, or a rubber into a microporous structure. In a foaming and forming process or a foaming polymer material, a honeycomb or porous structure is formed by adding and reacting a physical foaming agent or a chemical foaming agent.

A foaming agent, also referred to as a foaming material, is a material that can generate bubbles in a plastic, a silica gel, or a rubber to make the plastic, the silica gel, or the rubber into a porous substance. The foaming agent includes but is not limited to azo compounds, sulfonyl hydrazine compounds, nitrite compounds, sodium bicarbonate, sodium carbonate, n-pentane, n-hexane, n-heptane, petroleum ether (also referred to as naphtha), trichlorofluoromethane, dichlorodifluoromethane, and dichlorotetrafluoroethane.

A component is an electronic element and a small constituent part, usually consists of several parts, and can be used in similar products. The component includes but is not limited to a camera module, a display module, a sensor, and an earpiece. Some components (such as a camera and a display) that are vulnerable to electromagnetic interference signals have a shielding cover, and the shielding cover is connected to a reference ground through an electrically conductive elastic connector, so that signal shielding can be implemented.

Static electricity: An electrostatic phenomenon a common phenomenon in people's life. The static electricity is electric charges that converge on a surface of an object. The convergence of the static electricity generates a high potential on the surface of the object. With increasing functions of an electronic device, a distance between a circuit inside the electronic device and a surface of the electronic device is increasingly close, and static electricity on the surface of the electronic device or static electricity on a surface of an external object may enter the electronic device through a gap on the surface of the electronic device, thereby affecting normal operation of an electronic component.

Electromagnetic interference (electromagnetic interference, EMI for short): There are two types of electromagnetic interference: conducted interference and radiated interference. Conducted interference refers to coupling of signals from one electrical network to another electrical network through a conductive medium. Radiated interference refers to coupling of signals of an interference source to another electrical network through space. Electromagnetic interference in embodiments of this application is radiated interference. In a high-speed printed circuit board (printed circuit board, PCB for short) and system design, a high-frequency signal line, a pin of an integrated circuit, various connectors, and the like may become a radiation interference source having an antenna feature, and can emit an electromagnetic wave and affect normal operation of another system or another subsystem in the system.

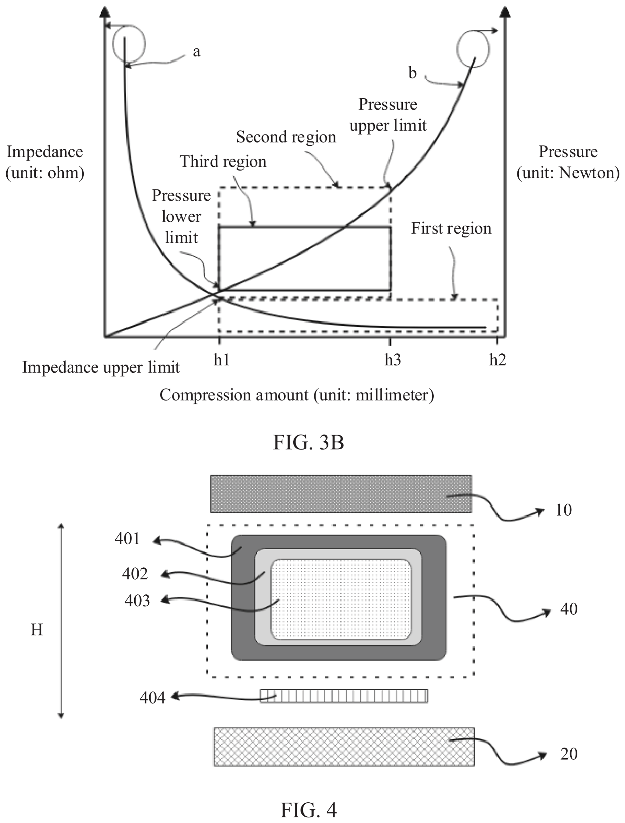

Operating range: As shown in FIG. 3B, an operating range of an electrically conductive elastic connector is a range of a horizontal coordinate (compression amount) corresponding to a third region. In this embodiment of this application, the compression range of the electrically conductive elastic connector corresponding to the third region in which an impedance requirement and a pressure requirement are met is defined as the operating range of the electrically conductive elastic connector.

As functions of a mobile phone become increasingly rich, an antenna on the mobile phone covers more frequency bands, and a thickness of the entire mobile phone becomes smaller, a grounding requirement in a radio frequency field becomes increasingly important. An antenna clutter problem needs to be resolved, and antenna performance needs to be improved. In addition, electromagnetic interference between components or modules needs to be reduced, an anti-interference capability of the components needs to be improved, and an EMC (electromagnetic compatibility, electro-magnetic compatibility) is considered. For example, when the antenna receives and sends signals, a display is prone to flicker due to interference from a radio frequency signal, or a camera module is prone to interference from a radio frequency signal. In addition, ESD (electro-static discharge, electro-static discharge) is also a problem that needs to be resolved. For example, for an antenna, non-linear introduction of other spurious radiation needs to be avoided, to ensure radiation performance of the antenna.

To reduce radio frequency interference between components, increase isolation between components, reduce a component damage risk caused by ESD, improve operating performance of the components (for example, improve operating performance of an antenna and a display module), and the like, a radio frequency terminal device needs to be grounded. For example, the camera module needs to be grounded, the antenna module needs to be grounded, and a rear cover or a middle frame of the electronic device needs to be grounded.

In an electronic device such as a mobile phone, a television, a display, a notebook computer, a palmtop computer, or an in-vehicle navigation system, an electrically conductive elastic connector is usually used to implement grounding of a component that needs to be grounded. Grounding includes connecting to a reference ground. It should be understood that the component includes a shielding cover or a shielding can used for grounding on the electronic device.

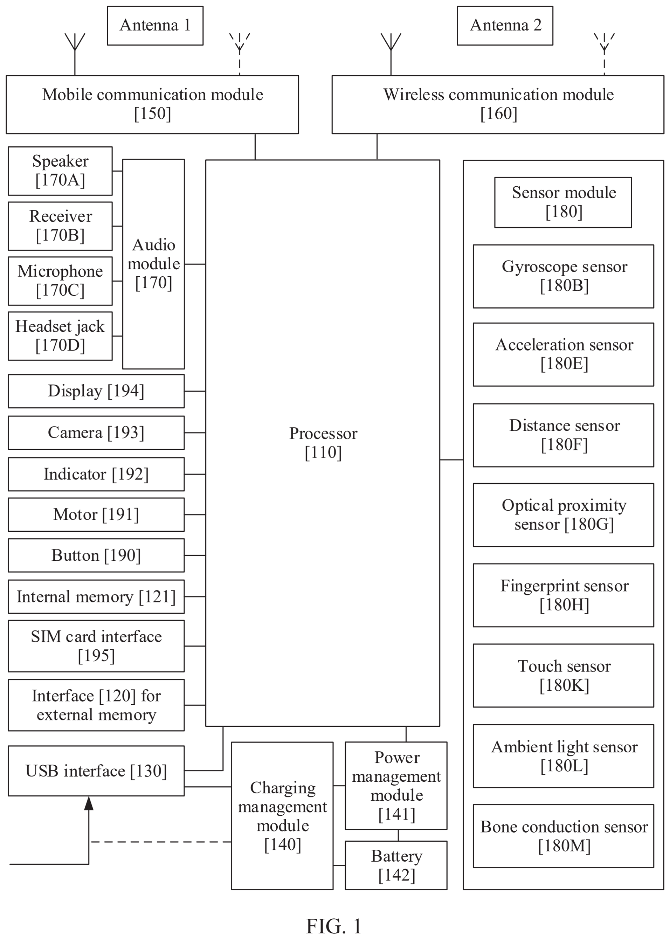

FIG. 1 is a diagram of a structure of an electronic device including a display module, a camera module, and an antenna.

The electronic device 100 may include at least one of a mobile phone, a foldable electronic device, a tablet computer, a desktop computer, a laptop computer, a handheld computer, a notebook computer, an ultra-mobile personal computer (ultra-mobile personal computer, UMPC for short), a netbook, a cellular phone, a personal digital assistant (personal digital assistant, PDA for short), an augmented reality (augmented reality, AR for short) device, a virtual reality (virtual reality, VR for short) device, an artificial intelligence (artificial intelligence, AI for short) device, a wearable device, a vehicle-mounted device, a smart home device, or a smart city device. A specific type of the electronic device 100 is not specifically limited in embodiments of this application.

The electronic device 100 may include a processor 110, an interface 120 for external memory, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a button 190, a motor 191, an indicator 192, a camera module 193, a display 194, a subscriber identity module (subscriber identity module, SIM for short) card interface 195, and the like. The sensor module 180 may include a pressure sensor 180A, a gyroscope sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, or the like.

It can be understood that the structure illustrated in this embodiment of this application does not constitute a specific limitation on the electronic device 100. In some other embodiments of this application, the electronic device 100 may include more or fewer components than those shown in the figure, or a combination of some components, or splits from some components, or a different component layout. The components shown in the figure may be implemented by using hardware, software, or a combination of software and hardware.

The processor 110 may include one or more processing units. For example, the processor 110 may include an application processor (application processor, AP for short), a modem processor, a graphics processing unit (graphics processing unit, GPU for short), an image signal processor (image signal processor, ISP for short), a controller, a video codec, a digital signal processor (digital signal processor, DSP for short), a baseband processor, a neural-network processing unit (neural-network processing unit, NPU for short), and/or the like. Different processing units may be independent components, or may be integrated into one or more processors. In some embodiments, the processor may include a first processor 1101 (for example, a collaborative processor) and a second processor 1102 (for example, an application processor).

The processor may generate an operation control signal based on instruction operation code and a time sequence signal, to complete control instruction fetching and instruction execution.

A memory may be further disposed in the processor 110, and is configured to store instructions and data. In some embodiments, the memory in the processor 110 may be a cache. The memory may store instructions or data just used or frequently used by the processor 110. If the processor 110 needs to use the instructions or the data, the processor 110 may directly invoke the instructions or the data from the memory. This avoids repeated access, reduces waiting time of the processor 110, and improves system efficiency.

In some embodiments, the processor 110 may include one or more interfaces. The interfaces may include an inter-integrated circuit (inter-integrated circuit, I2C for short) interface, an inter-integrated circuit sound (inter-integrated circuit sound, I2S for short) interface, a pulse code modulation (pulse code modulation, PCM for short) interface, a universal asynchronous receiver/transmitter (universal asynchronous receiver/transmitter, UART for short) interface, a mobile industry processor interface (mobile industry processor interface, MIPI for short), a general-purpose input/output (general-purpose input/output, GPIO for short) interface, a subscriber identity module (subscriber identity module, SIM for short) interface, a universal serial bus (universal serial bus, USB for short) interface, and/or the like. The processor 110 may be connected to a module such as a touch sensor, an audio module, a wireless communication module, a display, and a camera through at least one of the foregoing interfaces.

It may be understood that an interface connection relationship between the modules illustrated in embodiments of this application is merely an example for description, and does not constitute a limitation on the structure of the electronic device 100. In some other embodiments of this application, the electronic device 100 may alternatively use an interface connection manner different from that in the foregoing embodiment, or use a combination of a plurality of interface connection manners.

The USB interface 130 is an interface complying with a USB standard specification, and may be configured to connect the electronic device 100 and a peripheral device, and may be specifically a mini USB interface, a micro USB interface, a USB type-C interface, or the like. The USB interface 130 may be configured to connect to a charger, so that the charger charges the electronic device 100, or may be configured to connect to another electronic device, to implement data transmission between the electronic device 100 and the another electronic device. The USB interface 130 may alternatively be configured to connect to a headset, to output, through the headset, audio stored in the electronic device. The interface may be further configured to connect to another electronic device, for example, a VR device. In some embodiments, standard specifications of the universal serial bus may be USB 1.x, USB 2.0, USB 3.x, and USB 4.

The charging management module 140 is configured to receive a charging input of the charger. The charger may be a wireless charger or a wired charger. In some embodiments of wired charging, the charging management module 140 may receive a charging input from a wired charger through the USB interface 130. In some embodiments of wireless charging, the charging management module 140 may receive a wireless charging input through a wireless charging coil of the electronic device 100. The charging management module 140 supplies power to the electronic device through the power management module 141 while charging the battery 142. In some embodiments, the charging management module 140 needs to be grounded. Alternatively, a shielding cover needs to be added to the charging management module 140, and the shielding cover is grounded. In this way, mutual interference between the charging management module 140 and another module (for example, an antenna or a radio frequency device) can be avoided.

The power management module 141 is configured to connect to the battery 142, the charging management module 140, and the processor 110. The power management module 141 receives inputs from the battery 142 and/or the charging management module 140, and supplies power to the processor 110, the internal memory 121, the display 194, the camera module 193, the wireless communication module 160, and the like. The power management module 141 may be further configured to monitor parameters such as a battery capacity, a battery cycle count, and a battery health status (electric leakage or impedance). In some other embodiments, the power management module 141 may alternatively be disposed in the processor 110. In some other embodiments, the power management module 141 and the charging management module 140 may alternatively be disposed in a same device.

A wireless communication function of the electronic device 100 may be implemented by using the antenna 1, the antenna 2, the mobile communication module 150, the wireless communication module 160, the modem processor, the baseband processor, and the like.

The antenna 1 and the antenna 2 are configured to transmit and receive electromagnetic wave signals. Each antenna in the electronic device 100 may be configured to cover one or more communication frequency bands. Different antennas may also be reused to improve antenna utilization. For example, the antenna 1 may be reused as a diversity antenna of a wireless local area network. In some other embodiments, the antenna may be used in combination with a tuning switch.

The mobile communication module 150 may provide a wireless communication solution that is applied to the electronic device 100 and that includes a 2G/3G/4G/5G or the like. The mobile communication module 150 may include at least a filter, a switch, a power amplifier, a low noise amplifier (low noise amplifier, LNA for short), and the like. The mobile communication module 150 may receive an electromagnetic wave through the antenna 1, perform processing like filtering or amplification on the received electromagnetic wave, and transmit the electromagnetic wave to the modem processor for demodulation. The mobile communication module 150 may further amplify a signal modulated by the modem processor, and convert the signal into an electromagnetic wave for radiation through the antenna 1. In some embodiments, at least some functional modules in the mobile communication module 150 may be disposed in the processor 110. In some embodiments, at least some functional modules in the mobile communication module 150 may be disposed in a same device as at least some modules of the processor 110.

The modem processor may include a modulator and a demodulator. The modulator is configured to modulate a to-be-transmitted low-frequency baseband signal into a medium-high frequency signal. The demodulator is configured to demodulate a received electromagnetic wave signal into a low frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal through an audio device (not limited to the speaker 170A, the receiver 170B, and the like), and displays an image or a video through the display 194. In some embodiments, the modem processor may be an independent component. In some other embodiments, the modem processor may be independent of the processor 110, and is disposed in a same device as the mobile communication module 150 or another functional module.

The wireless communication module 160 may provide a wireless communication solution that includes a wireless local area network (wireless local area network, WLAN for short) (for example, a wireless fidelity (wireless fidelity, Wi-Fi for short) network), Bluetooth (Bluetooth, BT for short), Bluetooth low energy (Bluetooth low energy, BLE for short), ultra-wideband (ultra-wideband, UWB for short), a global navigation satellite system (global navigation satellite system, GNSS for short), frequency modulation (frequency modulation, FM for short), a near field communication (near field communication, NFC for short) technology, an infrared (infrared, IR for short) technology, or the like and that is applied to the electronic device 100. The wireless communication module 160 may be one or more components integrating at least one communication processor module. The wireless communication module 160 receives an electromagnetic wave through the antenna 2, performs frequency modulation and filtering processing on an electromagnetic wave signal, and sends a processed signal to the processor 110. The wireless communication module 160 may further receive a to-be-transmitted signal from the processor 110, perform frequency modulation and amplification on the signal, and convert the signal into an electromagnetic wave for radiation through the antenna 2.

In some embodiments, in the electronic device 100, the antenna 1 and the mobile communication module 150 are coupled, and the antenna 2 and the wireless communication module 160 are coupled, so that the electronic device 100 can communicate with a network and another device by using a wireless communication technology. The wireless communication technology may include a global system for mobile communications (global system for mobile communications, GSM for short), a general packet radio service (general packet radio service, GPRS for short), code division multiple access (code division multiple access, CDMA for short), wideband code division multiple access (wideband code division multiple access, WCDMA for short), time-division code division multiple access (time-division code division multiple access, TD-SCDMA for short), long term evolution (long term evolution, LTE for short), BT, a GNSS, a WLAN, NFC, FM, an IR technology, and/or the like. The GNSS may include a global positioning system (global positioning system, GPS for short), a global navigation satellite system (global navigation satellite system, GLONASS for short), a BeiDou navigation satellite system (BeiDou navigation satellite system, BDS for short), a quasi-zenith satellite system (quasi-zenith satellite system, QZSS for short), and/or a satellite based augmentation system (satellite based augmentation system, SBAS for short).

In some embodiments, the antenna 1 and the antenna 2 need to be grounded. In this way, a radiation function of the antenna is implemented, and electromagnetic radiation generated by the antenna can be prevented from being coupled to another module, to avoid interference. For example, electromagnetic radiation generated by the antenna is easily coupled to the display or the camera module, and affects normal operation of the display or the camera module. It should be understood that, in some embodiments, the antenna 1 and/or the antenna 2 may be mounted in the electronic device in a form of an antenna module. The module includes an antenna and a radio frequency integrated circuit.

The electronic device 100 may implement a display function through the GPU, the display 194, the application processor, and the like. The GPU is a microprocessor for image processing, and is connected to the display 194 and the application processor. The GPU is configured to: perform mathematical and geometric computation, and render an image. The processor 110 may include one or more GPUs that execute program instructions to generate or change display information.

The display 194 is configured to display an image, a video, and the like. The display 194 includes a display panel. The display panel may be a liquid crystal display (liquid crystal display, LCD for short), an organic light-emitting diode (organic light-emitting diode, OLED for short), an active-matrix organic light emitting diode (active-matrix organic light emitting diode, AMOLED for short), a flexible light-emitting diode (flexible light-emitting diode, FLED for short), a mini-LED, a micro-LED, a micro-OLED, a quantum dot light emitting diode (quantum dot light emitting diode, QLED for short), or the like. In some embodiments, the electronic device 100 may include one or more displays 194.

In some embodiments, the display 194 needs to be grounded. Grounding can enhance an anti-interference capability of the display 194, and avoid abnormal display of the display due to noise caused by electromagnetic interference.

The electronic device 100 may implement a photographing function via the camera module 193, the ISP, the video codec, the GPU, the display 194, the application processor AP, the neural-network processing unit NPU, and the like.

The camera module 193 may be configured to collect color image data and depth data of a photographed object. The ISP may be configured to process the color image data collected by the camera module 193. For example, during photographing, a shutter is opened, and light is transferred to a photosensitive element of the camera through a lens. An optical signal is converted into an electrical signal, and the photosensitive element of the camera transfers the electrical signal to the ISP for processing, to convert the electrical signal into a visible image. The ISP may further perform algorithm optimization on noise, brightness, and color of the image. In some embodiments, the ISP may be disposed in the camera module 193.

In some embodiments, the camera module 193 may include a color camera module and a 3D sensing module.

In some embodiments, a photosensitive element of a camera of the color camera module may be a charge coupled device (charge coupled device, CCD for short) or a complementary metal-oxide-semiconductor (complementary metal-oxide-semiconductor, CMOS for short) photoelectric transistor. The photosensitive element converts an optical signal into an electrical signal, and then transmits the electrical signal to the ISP for converting the electrical signal into a digital image signal. The ISP outputs the digital image signal to the DSP for processing. The DSP converts the digital image signal into an image signal in a standard format such as RGB or YUV.

In some embodiments, the 3D sensing module may be a (time of flight, TOF for short) 3D sensing module or a structured light (structured light) 3D sensing module. Structured light 3D sensing is an active depth sensing technology, and basic components of the structured light 3D sensing module may include an infrared (Infrared) transmitter, an IR camera module, and the like. A working principle of the structured light 3D sensing module is to first transmit a light spot of a specific pattern (pattern) to a photographed object, and then receive coding (light coding) of the light spot of the pattern on a surface of the object, to compare the light spot with an original projected light spot in terms of a similarity and a difference, and calculate three-dimensional coordinates of the object according to a trigonometric principle. The three-dimensional coordinates include a distance between the electronic device 100 and the photographed object. TOF 3D sensing may be an active depth sensing technology. Basic components of the TOF 3D sensing module may include an infrared (Infrared) transmitter, an IR camera module, and the like. A working principle of the TOF 3D sensing module is to calculate a distance (that is, a depth) between the TOF 3D sensing module and a photographed object by using infrared refraction time, to obtain a 3D depth-of-field image.

The structured light 3D sensing module may be further applied to fields such as somatic game console, and industrial machine vision detection. The TOF 3D sensing module may be further applied to fields such as a game console and augmented reality (augmented reality, AR for short)/virtual reality (virtual reality, VR for short).

In some other embodiments, the camera module 193 may further include two or more cameras. The two or more cameras may include a color camera, and the color camera may be configured to collect color image data of a photographed object. The two or more cameras may collect depth data of a photographed object by using a stereo vision (stereo vision) technology. The stereo vision technology is based on a principle of a parallax of human eyes. Under a natural light source, two or more cameras are used to photograph an image of a same object from different angles, and then an operation such as a triangulation method is performed to obtain distance information, that is, depth information, between the electronic device 100 and the photographed object.

In some embodiments, the electronic device 100 may include one or more camera modules 193. Specifically, the electronic device 100 may include one front-facing camera module 193 and one rear-facing camera module 193. The front-facing camera module 193 may be usually configured to collect color image data and depth data of a photographer facing the display 194, and the rear-facing camera module may be configured to collect color image data and depth data of a photographed object (such as a character or a scenery) facing the photographer.

In some embodiments, the CPU, the GPU, or the NPU in the processor 110 may process color image data and depth data that are collected by the camera module 193. In some embodiments, the NPU may identify, according to a neural network algorithm by using a skeleton point identification technology, for example, a convolutional neural network (CNN) algorithm, color image data collected by the camera module 193 (specifically, the color camera module), to determine a skeleton point of the subject. The CPU or the GPU may also run a neural network algorithm to determine the skeleton point of the subject based on the color image data. In some embodiments, the CPU, the GPU, or the NPU may be further configured to: determine the figure (for example, a body proportion and a fatness and thinness degree of a body part between skeleton points) of the subject based on depth data collected by the camera module 193 (which may be the 3D sensing module) and the identified skeleton point, further determine a body beautification parameter for the subject, and finally process a photographed image of the subject based on the body beautification parameter, so that a body shape of the subject in the photographed image is beautified.

The digital signal processor is configured to process a digital signal, and may further process another digital signal. For example, when the electronic device 100 selects a frequency, the digital signal processor is configured to perform Fourier transformation on frequency energy.

The video codec is configured to compress or decompress a digital video. The electronic device 100 may support one or more video codecs. Therefore, the electronic device 100 may play or record videos in a plurality of coding formats, for example, moving picture experts group (moving picture experts group, MPEG for short)-1, MPEG-2, MPEG-3, and MPEG-4.

The NPU is a neural-network (neural-network, NN for short) computing processor. The NPU quickly processes input information by referring to a structure of a biological neural network, for example, a transfer mode between human brain neurons, and may further continuously perform self-learning. Applications such as intelligent cognition of the electronic device 100 may be implemented through the NPU, for example, image recognition, facial recognition, speech recognition, and text understanding.

The interface 120 for external memory may be used to connect to an external memory card, for example, a micro SD card, to extend a storage capability of the electronic device 100. The external memory card communicates with the processor 110 through the interface 120 for external memory, to implement a data storage function. For example, files such as music and videos are stored in the external memory card. Alternatively, files such as music and a video are transmitted from the electronic device to the external memory card.

The internal memory 121 may be configured to store computer-executable program code. The executable program code includes instructions. The internal memory 121 may include a program storage area and a data storage area. The program storage area may store an operating system, an application required by at least one function (for example, a voice playing function or an image playing function), and the like. The data storage area may store data (such as audio data and an address book) created during use of the electronic device 100, and the like. In addition, the internal memory 121 may include a high-speed random access memory, or may include a nonvolatile memory, for example, at least one magnetic disk storage device, a flash memory, or a universal flash storage (universal flash storage, UFS for short). The processor 110 runs the instructions stored in the internal memory 121, and/or the instructions stored in the memory disposed in the processor, to perform various function methods of the electronic device 100 and data processing.

The electronic device 100 may implement audio functions such as music playing and recording, through the audio module 170, the speaker 170A, the receiver 170B, the microphone 170C, the headset jack 170D, the application processor, and the like.

The audio module 170 is configured to convert digital audio information into an analog audio signal for output, and is also configured to convert an analog audio input into a digital audio signal. The audio module 170 may be configured to encode and decode an audio signal. In some embodiments, the audio module 170 may be disposed in the processor 110, or some functional modules of the audio module 170 are disposed in the processor 110.

The speaker 170A, also referred to as a "loudspeaker", is configured to convert an audio electrical signal into a sound signal. The electronic device 100 may listen to music or output an audio signal of a hands-free call by using the speaker 170A.

The receiver 170B, also referred to as an "earpiece", is configured to convert an electrical audio signal into a sound signal. When a call is answered or a voice message is received through the electronic device 100, the receiver 170B may be put close to a human ear to listen to a voice.

The microphone 170C, also referred to as a "mike" or a "mic", is configured to convert a sound signal into an electrical signal. When making a call or sending voice information, the user may make a sound near the microphone 170C through the mouth of the user, to enter a sound signal to the microphone 170C. At least one microphone 170C may be disposed in the electronic device 100. In some other embodiments, two microphones 170C may be disposed in the electronic device 100, to collect a sound signal and implement a noise reduction function. In some other embodiments, three, four, or more microphones 170C may alternatively be disposed in the electronic device 100, to collect a sound signal, implement noise reduction, and identify a sound source, to implement a directional recording function and the like.

The headset jack 170D is configured to connect to a wired headset. The headset jack 170D may be the USB interface 130, or may be a 3.5 mm open mobile terminal platform (open mobile terminal platform, OMTP for short) standard interface, or a cellular telecommunications industry association of the USA (cellular telecommunications industry association of the USA, CTIA for short) standard interface.

The pressure sensor 180A is configured to sense a pressure signal, and can convert the pressure signal into an electrical signal. In some embodiments, the pressure sensor 180A may be disposed on the display 194. There are a plurality of types of pressure sensors 180A, such as a resistive pressure sensor, an inductive pressure sensor, and a capacitive pressure sensor. The capacitive pressure sensor may include at least two parallel plates made of conductive materials. When a force is applied to the pressure sensor 180A, capacitance between electrodes changes. The electronic device 100 determines pressure intensity based on the change of the capacitance. When a touch operation is performed on the display 194, the electronic device 100 detects intensity of the touch operation by using the pressure sensor 180A. The electronic device 100 may also calculate a touch location based on a detection signal of the pressure sensor 180A. In some embodiments, touch operations that are performed in a same touch location but have different touch operation intensity may correspond to different operation instructions. For example, when a touch operation whose touch operation intensity is less than a first pressure threshold is performed on an SMS message application icon, an instruction for viewing an SMS message is performed. When a touch operation whose touch operation intensity is greater than or equal to the first pressure threshold is performed on the SMS message application icon, an instruction for creating a new SMS message is performed.

The gyroscope sensor 180B may be configured to determine a moving posture of the electronic device 100. In some embodiments, an angular velocity of the electronic device 100 around three axes (namely, axes x, y, and z) may be determined through the gyroscope sensor 180B. The gyroscope sensor 180B may be configured to implement image stabilization during photographing. For example, when a shutter is pressed, the gyroscope sensor 180B detects an angle at which the electronic device 100 jitters, obtains, through calculation based on the angle, a distance for which a lens module needs to compensate, and controls reverse motion of the lens to cancel the jitter of the electronic device 100, to implement image stabilization. The gyroscope sensor 180B may also be used in a navigation scenario and a somatic game scenario.

The barometric pressure sensor 180C is configured to measure barometric pressure. In some embodiments, the electronic device 100 calculates an altitude based on a value of the barometric pressure measured by the barometric pressure sensor 180C, to assist in positioning and navigation.

The magnetic sensor 180D includes a Hall sensor. The electronic device 100 may detect opening and closing of a flip cover by using the magnetic sensor 180D. When the electronic device is a foldable electronic device, the magnetic sensor 180D may be configured to detect folding or unfolding, or a folding angle of the electronic device. In some embodiments, when the electronic device 100 is a clamshell phone, the electronic device 100 may detect opening and closing of a flip cover based on the magnetic sensor 180D. Further, a feature like automatic unlocking of the flip cover is set based on a detected opening or closing state of the leather case or a detected opening or closing state of the flip cover.

The acceleration sensor 180E may detect accelerations of the electronic device 100 in various directions (usually on three axes). When the electronic device 100 is still, a magnitude and a direction of gravity may be detected. The acceleration sensor 180E may be further configured to identify a posture of the electronic device, and is used in an application such as switching between a landscape mode and a portrait mode or a pedometer.

The distance sensor 180F is configured to measure a distance. The electronic device 100 may measure a distance through infrared or laser. In some embodiments, in a photographing scenario, the electronic device 100 may measure a distance by using the distance sensor 180F, to implement quick focusing.

The optical proximity sensor 180G may include, for example, a light-emitting diode (LED) and an optical detector, for example, a photodiode. The light emitting diode may be an infrared light emitting diode. The electronic device 100 emits infrared light by using the light emitting diode. The electronic device 100 detects infrared reflected light from a nearby object by using the photodiode. When intensity of detected reflected light is greater than a threshold, it may be determined that there is an object near the electronic device 100. When intensity of the detected reflected light is less than a threshold, the electronic device 100 may determine that there is no object near the electronic device 100. The electronic device 100 may detect, by using the optical proximity sensor 180G, that the user holds the electronic device 100 close to an ear for a call, to automatically turn off a screen for power saving. The optical proximity sensor 180G may also be used in a smart cover mode or a pocket mode to automatically perform screen unlocking or locking.

The ambient light sensor 180L may be configured to sense ambient light brightness. The electronic device 100 may adaptively adjust brightness of the display 194 based on the sensed ambient light brightness. The ambient light sensor 180L may also be configured to automatically adjust white balance during photographing. The ambient light sensor 180L may also cooperate with the optical proximity sensor 180G to detect whether the electronic device 100 is blocked. For example, the electronic device is in a pocket. When it is detected that the electronic device is blocked or is in a pocket, some functions (for example, a touch function) may be disabled, to prevent a misoperation.

The fingerprint sensor 180H is configured to collect a fingerprint. The electronic device 100 may implement fingerprint unlock, access app lock, fingerprint photographing, fingerprint incoming call answering, and the like by using an acquired fingerprint feature.

The temperature sensor 180J is configured to detect a temperature. In some embodiments, the electronic device 100 executes a temperature processing policy based on the temperature detected by the temperature sensor 180J. For example, when the temperature detected by the temperature sensor 180J exceeds a threshold, the electronic device 100 lowers performance of a processor, to reduce power consumption of the electronic device to implement thermal protection. In some other embodiments, when the temperature detected by the temperature sensor 180J is less than another threshold, the electronic device 100 heats the battery 142. In some other embodiments, when the temperature is less than still another threshold, the electronic device 100 may boost an output voltage of the battery 142.

The touch sensor 180K is also referred to as a "touch component". The touch sensor 180K may be disposed on the display 194, and the touch sensor 180K and the display 194 constitute a touchscreen, which is also referred to as a "touchscreen". The touch sensor 180K is configured to detect a touch operation performed on or near the touch sensor. The touch sensor may transfer the detected touch operation to the application processor, to determine a type of a touch event. A visual output related to the touch operation may be provided through the display 194. In some other embodiments, the touch sensor 180K may also be disposed on a surface of the electronic device 100 at a location different from that of the display 194.

The bone conduction sensor 180M may obtain a vibration signal. In some embodiments, the bone conduction sensor 180M may obtain a vibration signal of a vibration bone of a human vocal-cord part. The bone conduction sensor 180M may also be in contact with a body pulse to receive a blood pressure beating signal. In some embodiments, the bone conduction sensor 180M may alternatively be disposed in a headset to be combined into a bone conduction headset. The audio module 170 may parse out a voice signal based on the vibration signal that is of the vibration bone of the vocal-cord part and that is obtained by the bone conduction sensor 180M, to implement a voice function. The application processor may parse heart rate information based on the blood pressure beating signal obtained by the bone conduction sensor 180M, to implement a heart rate detection function.

The button 190 may include a power button, a volume button, and the like. The button 190 may be a mechanical button, or may be a touch button. The electronic device 100 may receive a button input, and generate a button signal input related to user settings and function control of the electronic device 100.

The motor 191 may generate a vibration prompt. The motor 191 may be configured to provide an incoming call vibration prompt and a touch vibration feedback. For example, touch operations performed on different applications (for example, photographing and audio playing) may correspond to different vibration feedback effects. The motor 191 may also correspond to different vibration feedback effects for touch operations performed on different regions of the display 194. Different application scenarios (for example, a time reminder, information receiving, an alarm clock, and a game) may also correspond to different vibration feedback effects. A touch vibration feedback effect may be further customized.

The indicator 192 may be an indicator light, and may be configured to indicate a charging status and a power change, or may be configured to indicate a message, a missed call, a notification, and the like.

The SIM card interface 195 is configured to connect to a SIM card. The SIM card may be inserted into the SIM card interface 195 or detached from the SIM card interface 195, to implement contact with or separation from the electronic device 100. The electronic device 100 may support one or more SIM card interfaces. The SIM card interface 195 may support a nano-SIM card, a micro-SIM card, a SIM card, and the like. A plurality of cards may be simultaneously inserted into a same SIM card interface 195. The plurality of cards may be of a same type or different types. The SIM card interface 195 is also compatible with different types of SIM cards. The SIM card interface 195 is also compatible with an external memory card. The electronic device 100 interacts with a network by using the SIM card, to implement functions such as conversation and data communication. In some embodiments, the electronic device 100 uses an eSIM, that is, an embedded SIM card. The eSIM card may be embedded into the electronic device 100, and cannot be separated from the electronic device 100.

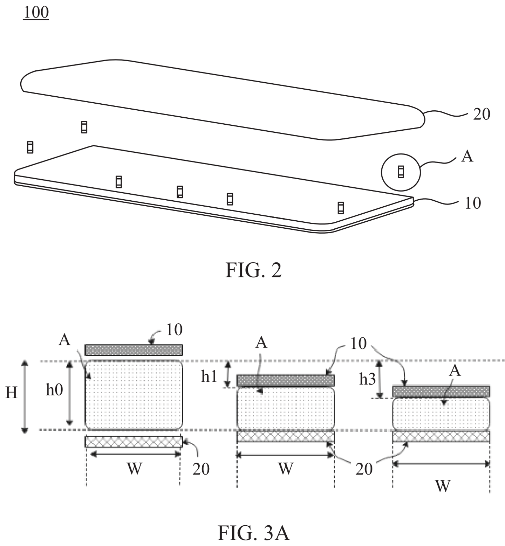

FIG. 2 shows an example of an electronic device 100 for electrical connection through an electrically conductive elastic connector according to an embodiment of this application. The electronic device 100 may include a first element 10, an electrically conductive elastic connector A, and a second element 20. The electrically conductive elastic connector A is disposed between the first element 10 and the second element 20, and the first element 10 and the second element 20 are electrically connected through the electrically conductive elastic connector A. Specifically, the electrically conductive elastic connector A has a first surface and a second surface that are disposed opposite to each other in a first direction (for example, a height direction). The first surface is electrically connected to the first element, and the second surface is electrically connected to the second element. In some embodiments, the first element 10 may be a middle frame of the electronic device, and the middle frame is grounded.

In some embodiments, the second element 20 may be a display module, and the first element 10 is a middle frame of the electronic device. The display module may be connected to the middle frame through the electrically conductive elastic connector A to implement grounding. Specifically, the middle frame is electrically connected to the first surface of the electrically conductive elastic connector A, and the display module is electrically connected to the second surface of the electrically conductive elastic connector A.

In some other embodiments, the second element 20 may be a shielding cover, and the first element 10 may be a middle frame of the electronic device. The second element 20 and the first element 10 are electrically connected through the electrically conductive elastic connector A, so that the shielding cover is grounded. It should be understood that the shielding cover may be disposed on an outer surface of a component (for example, a radio frequency front-end module) inside the electronic device to implement grounding.

In some other embodiments, the second element 20 is a camera module, and the second element 10 is a middle frame of the electronic device. The camera module is electrically connected to the middle frame through the electrically conductive elastic connector A, to implement grounding of the camera module.

In some other embodiments, the second element 20 is an antenna bracket, and the second element 10 is a middle frame of the electronic device. The antenna bracket is electrically connected to the middle frame through the electrically conductive elastic connector A to implement grounding.

In some embodiments, the electrically conductive elastic connector A may be further used to implement grounding of a PCB (Printed Circuit Board, printed circuit board), a cable, and the like.

FIG. 3A is a cross-sectional view of an electrically conductive elastic connector A. It should be understood that the electrically conductive elastic connector A is of a three-dimensional structure having a length, a width, and a height. In the structure of the electrically conductive elastic connector shown in FIG. 3A, the electrically conductive elastic connector includes a first contact surface (a surface connected to a first element 10) and a second contact surface (a surface connected to a second element 20) that are disposed opposite to each other in a first direction (for example, a height direction H), two side surfaces (namely, a left side surface and a right side surface, where the left side surface and the right side surface are not shown in the figure) that are disposed opposite to each other in a second direction (for example, a width direction W), and two side surfaces (not shown in the figure) that are disposed opposite to each other in a third direction (for example, a length direction L, where the length direction L is perpendicular to the width direction W and is perpendicular to the paper). In some embodiments, the first contact surface and the second contact surface may be in shapes such as a rectangle, a circle, an ellipse, and a trapezoid. It should be understood that the first contact surface and the second contact surface may be in different shapes. In other words, a contact surface that is of the electrically conductive elastic connector A and that is connected to the first element may be different from a contact surface that is of the electrically conductive elastic connector A and that is connected to the second element. For example, a display and a middle frame are connected through a conductive foam to implement grounding, and an area of a first contact surface between the spring plate and the display may be less than an area of a second contact surface between the spring plate and the middle frame.

The electrically conductive elastic connector shown in FIG. 3A is elastic, and an initial height of the electrically conductive elastic connector is h0. A height of the electrically conductive elastic connector is changed after the electrically conductive elastic connector is compressed, where a change amount of the height is a compression amount. For example, a compression amount of the electrically conductive elastic connector under pressure may be h1. If the electrically conductive elastic connector is further compressed, a compression amount of the electrically conductive elastic connector may reach h3, where h3 is greater than h1.

In this implementation, a cross section (namely, a cross section obtained by cutting along a plane HW, where the plane HW is a plane formed by the height direction H and the width direction W) of the electrically conductive elastic connector on the first contact surface and a cross section (namely, a cross section obtained by cutting along a plane HL, where the plane HL is a plane formed by the height direction H and the length direction L) of the electrically conductive elastic connector on the second contact surface are rectangles. A person skilled in the art may understand that, in another alternative implementation, the cross sections of the electrically conductive elastic connector on the first contact surface and the second contact surface may alternatively be in other shapes, for example, trapezoids. The shape may be appropriately set based on an actual use environment and use requirements, and does not limit the protection scope of this application herein.

In FIG. 3B, a curve a is a curve of a relationship between ground impedance and a compression amount of an electrically conductive elastic connector A when the electrically conductive elastic connector A is connected to a first element and a second element, where the first element is electrically connected to a reference ground. The ground impedance of the electrically conductive elastic connector A decreases as the compression amount increases. To meet a requirement that the ground impedance needs to be less than maximum ground impedance, a first region in which ground impedance is less than an impedance upper limit is a workable region in which impedance meets the requirement. In other words, a compression amount of the electrically conductive elastic connector A needs to be in the first region (for example, the compression amount ranges from h1 to h2 shown in FIG. 3A) to meet the ground impedance requirement. Therefore, the compression amount of the electrically conductive elastic connector A needs to reach a minimum compression amount, and a compression amount greater than the minimum compression amount is a compression range in which a grounding requirement is met. It should be understood that h2 in FIG. 3A may be infinitely close to a thickness of the electrically conductive elastic connector A. In some embodiments, the ground impedance upper limit is 0.2 ohm, and ground impedance less than 0.2 ohm is referred to as low impedance.

Different electrically conductive elastic connectors A correspond to different curves (curve a) of relationships between ground impedance and compression amounts. For example, as a compression amount increases, a rate at which ground impedance of a first electrically conductive elastic connector A decreases as the compression amount increases may be greater than that of a first connector B. In this case, to reduce the ground impedance to an impedance upper limit, a minimum compression amount required by the first electrically conductive elastic connector A is less than a minimum compression amount required by the second electrically conductive elastic connector A. Therefore, it may be considered that a compression range in which the first electrically conductive elastic connector A meets an impedance requirement is larger. For example, heights of the first electrically conductive elastic connector A and the second electrically conductive elastic connector A are both 1.5 mm. The first electrically conductive elastic connector meets the ground impedance requirement when the compression amount is 0.2 mm, and the second electrically conductive elastic connector A needs to meet the ground impedance requirement when the compression amount is 0.5 mm. In this case, a compression range in which the first electrically conductive elastic connector A meets the impedance requirement is 0.2 mm to 1.5 mm, and a compression range in which the second electrically conductive elastic connector A meets the impedance requirement is 0.5 mm to 1.5 mm. Therefore, the compression range in which the first electrically conductive elastic connector A meets the impedance requirement is wider.

A curve b is a curve of a relationship between pressure applied to the electrically conductive elastic connector A (or pressure applied to the first element 10 and/or the second element 20) and a compression amount when the electrically conductive elastic connector A is connected to the first element and the second element. It can be seen that the pressure applied to the electrically conductive elastic connector A increases as the compression amount increases. It should be understood that, to meet a pressure requirement, the pressure needs to be between a pressure lower limit and a pressure upper limit. The pressure lower limit is a pressure value applied to the electrically conductive elastic connector A when the electrically conductive elastic connector A is at a compression amount at which an impedance requirement is met. The pressure upper limit is set to ensure that the first element and/or the second element are/is not damaged due to excessive pressure. For example, in an application scenario in which a display is grounded, because pressure is excessively high, a film imprint is generated on the flexible display due to the pressure, affecting aesthetics of the display.

In some embodiments, it is required that ground pressure be not greater than 0.5 Newton. Alternatively, for a common electrically conductive elastic connector, an area of a contact surface (a first surface and a second surface) between the electrically conductive elastic connector and the first element and/or the second element is 2.5 mm × 2.5 mm, and pressure intensity correspondingly generated by the electrically conductive elastic connector at the maximum compression amount is not greater than 0.08 MPa. It should be understood that, for different grounding scenarios, required pressure upper limits may be different.

A compression range region in which the electrically conductive elastic connector A meets the pressure requirement is a second region. Pressure generated by the electrically conductive elastic connector A needs to be greater than a minimum pressure value (which meets a pressure value corresponding to the impedance upper limit) and less than a maximum pressure value. In other words, to meet a pressure requirement, a compression amount of the electrically conductive elastic connector A has a range (for example, between h1 and h3, where h1 is a compression amount at which a maximum ground impedance requirement is met, and h3 is a compression amount corresponding to a pressure upper limit). It should be understood that different electrically conductive elastic connectors A have different pressure upper limits and/or pressure lower limits.

A region in which a compression range of the electrically conductive elastic connector A meets both an impedance requirement and a pressure requirement is a third region. A range in which compression amounts of the first region and the second region overlap is a compression range of the third region (for example, as shown in FIG. 3, the compression range of the first region is h1 to h2, and the compression range of the second region is h1 to h3, where h3 is less than h2. In this case, the compression range of the third region is h1 to h3). It should be noted that, in this embodiment of this application, the compression range of the electrically conductive elastic connector corresponding to the third region in which the impedance requirement and the pressure requirement are met is defined as the operating range of the electrically conductive elastic connector.

A wider compression range of the third region corresponding to the electrically conductive elastic connector A indicates a larger operating range in which the electrically conductive elastic connector A meets both the impedance requirement and the pressure requirement. It may be considered that the electrically conductive elastic connector A has a wider application scenario and a better grounding solution.

Generally, to implement a ground connection through the electrically conductive elastic connector A, an impedance requirement needs to be met. In other words, ground impedance is not greater than maximum ground impedance. In addition, as a structure of the electronic device is complex, light, and thin, and functions and forms of the electronic device are diversified, in addition to an impedance requirement, a pressure requirement that pressure is not greater than a maximum pressure upper limit needs to be met in the grounding solution. For example, in a scenario in which a display module is grounded, a pressure upper limit that the display module can bear is 5 Newton. Therefore, pressure generated by the electrically conductive elastic connector A needs to be less than 5 Newton. Otherwise, the display module is damaged. In addition, in some scenarios, for example, in a scenario in which a high-resolution camera is grounded, the electrically conductive elastic connector A needs to meet low-impedance and low-pressure grounding requirements, and needs to meet a low-harmonic grounding requirement, to avoid impact of harmonic noise on normal operation of the camera.

As shown in FIG. 4, an electronic device may use fabric over foam (fabric over foam, FOF foam for short) to connect a first element 10 and a second element 20. The FOF foam 40 has a first contact surface and a second contact surface that are disposed opposite to each other in a height H direction. The first contact surface is electrically connected to the first element 10, and the second contact surface is electrically connected to the second element 20. It should be understood that the FOF foam 40 includes at least a foam body 403, a hot melt adhesive layer 402 covering a surface of the foam body 403, and a conductive wrapping layer 401 covering a surface of the hot melt adhesive layer 402. The wrapping layer 401 may be a conductive fabric. It should be understood that a conductive adhesive 404 may be added between the FOF foam 40 and the first element 10 and/or the second element 20, to bond the FOF foam 40 and the first element 10 and/or the second element 20. It should be understood that, due to a limitation of a process, a minimum size of the wrapping layer 401 can only be at a micrometer level.

Because there are the compression-limited conductive wrapping layer 401 and the hot melt adhesive layer 402, the FOF foam cannot achieve a low working height. In addition, the FOF foam is prone to fracture due to compression, resulting in an increase in impedance.

An embodiment of this application provides an electrically conductive elastic connector. A porous foam body is used, and an electrically conductive layer of nanowires in an interior and on an outer surface of the porous foam body is formed, to form a foam core structure. The electrically conductive elastic connector can meet an impedance requirement and a pressure requirement in a wide operating range. In addition, because the electrically conductive elastic connector uses the nanowire as the electrically conductive layer, the electrically conductive elastic connector has an advantage of a low harmonic. In addition, an adhesive layer and a conductive film are respectively added to the first surface and the second surface of the foam core, and the conductive film is bonded by using the adhesive layer to increase bonding fastness between the foam core and the first element and between the foam core and the second element, to effectively avoid, under a condition of improving conductivity, a risk such as a short circuit caused by fracture, fall-off, or the like of the foam body to which the electrically conductive layer is attached.

An electrically conductive elastic connector provided in an embodiment of this application is used on an electronic device. Because the electrically conductive elastic connector has a wide operating range, the electrically conductive elastic connector is applicable to a plurality of application scenarios, to implement free connection between components of the electronic device or free grounding of the components. For example, the electrically conductive elastic connector may be applied to grounding of a display module, or may be applied to grounding of a camera module, or may be applied to grounding of an antenna bracket. In addition, because the electrically conductive elastic connector has a low harmonic characteristic, an electronic device using the electrically conductive elastic connector can avoid electromagnetic interference between components or modules, reduce an ESD phenomenon, and can be used for free grounding of a terminal device, a vehicle-mounted device, and the like. In addition, the electrically conductive elastic connector further has excellent reliability, and can implement long-term stable low harmonic performance.

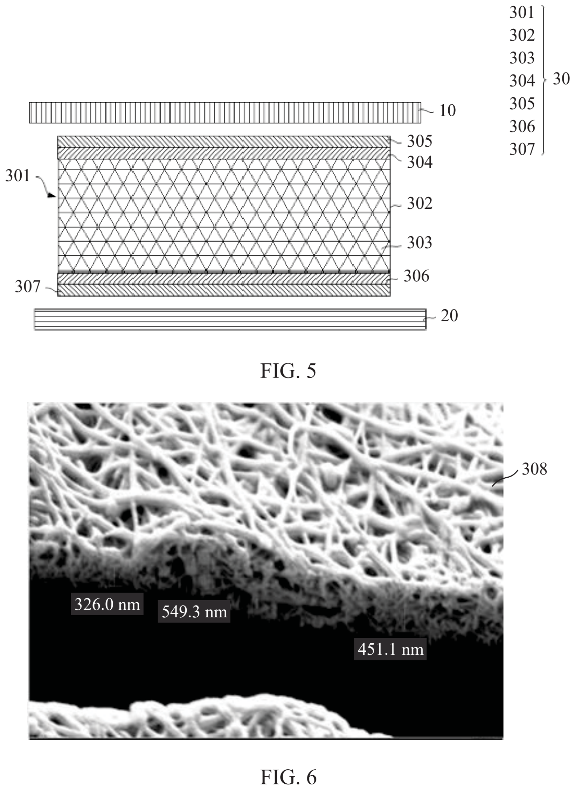

FIG. 5 is a cross-sectional view of an electrically conductive elastic connector according to an embodiment of this application along an HW plane (a plane formed by a height H direction and a width W direction). The electrically conductive elastic connector 30 includes a foam core 301. The foam core 301 includes a porous foam body 302. The porous foam body 302 may have a plurality of inner holes (not shown in the figure) and a plurality of outer holes 303. For example, as shown in FIG. 5, there are the plurality of outer holes 303 on the porous foam body 302.

The electrically conductive elastic connector 30 further includes an electrically conductive layer 308 (with reference to FIG. 6) located on the porous foam body 302. The electrically conductive layer is formed by attaching nanowires to an interior and an outer surface of the porous foam body 302. The nanowire may include but is not limited to at least one of a carbon nanotube, a tin nanowire, a copper nanowire, nano-nickel, nano-silver, and a gold nanowire.

The nanowire may be attached to the interior and the outer surface of the porous foam body 302 through coating and/or immersion. For example, a nanowire solution and a dendritic nanowire solution may be alternately coated in the interior and on the outer surface of the porous foam body 302 in a coating/immersion manner, to form a plurality of uniform electrically conductive layers on the porous foam body 302.

The electrically conductive layer of the nanowires in the interior and on the outer surface of the porous foam body 302 is formed, so that a problem of ground impedance deterioration caused by breaking of the electrically conductive layer can be reduced or avoided, stable low impedance within a large compression range can be implemented, and generation of a high harmonic wave can be avoided. Because the nanowires are used as the electrically conductive layer, strength of the nanowires and a bonding force between the nanowires and the foam body 302 are high, and a problem of unstable ground impedance caused by fall-off of the electrically conductive layer can also be reduced.

In addition, when the foam core 301 formed on the porous foam body 302 is compressed, pressure (or a rebound force) slowly increases, so that a compression range corresponding to a second region that is less than a pressure upper limit is wide. Therefore, a compression range of a third region of the electrically conductive elastic connector is wide. In other words, an operating range in which the electrically conductive elastic connector meets both an impedance requirement and a pressure requirement is wide.

The porous foam body 302 includes a first surface and a second surface that are disposed opposite to each other in a first direction (for example, a height direction). Shapes of the first surface and the second surface may be a rectangle, a circle, an ellipse, a trapezoid, or the like. It should be understood that shapes, sizes, and the like of the first surface and the second surface may be different or the same.

The electrically conductive elastic connector 30 further includes a first electrically conductive adhesion layer 304 and a first electrically conductive film 305. The first electrically conductive adhesion layer 304 is located on the first surface of the foam core 301, and the first electrically conductive film 305 is stacked on the first electrically conductive adhesion layer 304. In other words, the first electrically conductive adhesion layer 304 is located between the first electrically conductive film 305 and the first surface of the electrically conductive elastic connector 30. The first electrically conductive adhesion layer 304 is used to fasten the first electrically conductive film 305 layer to the first surface of the foam core 301.

The first electrically conductive film 305 is configured to electrically connect to the first element 10, to implement an electrical connection between the electrically conductive elastic connector 30 and the first element 10. A surface that is of the first electrically conductive film 305 and that is away from the first electrically conductive adhesion layer 304 may be used as a first contact surface of the electrically conductive elastic connector 30, and is connected to the first element 10.

The electrically conductive elastic connector 30 further includes a second electrically conductive adhesion layer 306 and a second electrically conductive film 307. The second electrically conductive adhesion layer 306 is located on the second surface of the foam core 301, and the second electrically conductive film 307 is stacked on the second electrically conductive adhesion layer 306. In other words, the second electrically conductive adhesion layer 306 is located between the second electrically conductive film 307 and the second surface of the electrically conductive elastic connector 30. The second electrically conductive adhesion layer 306 is used to fasten the second electrically conductive film 307 layer to the second surface of the foam core 301.

The second electrically conductive film 307 is configured to electrically connect to the second element 20, to implement an electrical connection between the electrically conductive elastic connector 30 and the second element 20, and further implement an electrical connection between the first element 10 and the second element 20. A surface that is of the second electrically conductive film 307 and that is away from the second electrically conductive adhesion layer 306 may be used as a second contact surface of the electrically conductive elastic connector 30, and is connected to the second element 20.

The first electrically conductive film 305 is bonded to the first electrically conductive adhesion layer 304, to enhance strength of the first electrically conductive adhesion layer 304, improve continuity of the first electrically conductive adhesion layer 304 in a pressure scenario, and reduce or avoid a phenomenon that the foam core 301 falls off the first element 10 because the first electrically conductive adhesion layer 304 is cracked or broken (for example, broken into a granular shape) when the electrically conductive elastic connector 30 is under pressure. Correspondingly, the second electrically conductive film 307 may also enhance strength of the second electrically conductive adhesion layer 306, improve continuity of the second electrically conductive adhesion layer 306 in a pressure scenario, and reduce or avoid a phenomenon that the foam core 301 falls off the second element 20 because the second electrically conductive adhesion layer 306 is cracked or broken under pressure, to effectively improve bonding fastness between the electrically conductive elastic connector 30 and the first element 10 and between the electrically conductive elastic connector 30 and the second element 20, and improve reliability of the electrically conductive elastic connector 30. A conductive elastomer with low pressure and low PIM (passive intermodulation, passive intermodulation for short) can be formed by bonding a conductive film on a foam body 302 attached with nanowires, and long-term stable low PIM performance can be achieved.

In this embodiment of this application, a thicknesses of the first electrically conductive film 305 and a thicknesses of the second electrically conductive film 307 are 0.01 mm to 0.1 mm. For example, the thicknesses of the first electrically conductive film 305 and the thicknesses of the second electrically conductive film 307 may be 0.08 mm, or may be 0.05 mm. A good enhancement effect can be achieved on the adhesion layer, and a problem such as breaking of the adhesion layer in a pressure scenario is reduced.

It may be understood that the thickness of the first electrically conductive film 305 and the thickness of the second electrically conductive film 307 may be the same or may be different.

In this embodiment of this application, the first electrically conductive film 305 and the second electrically conductive film 307 may be conductive fabrics, or may be copper foils, or may be other conductive structures with a fixed shape. However, the first electrically conductive film 305 and the second electrically conductive film 307 cannot be conductive adhesives.

The conductive fabric may be a nickel-plated fiber fabric, a gold-plated fiber fabric, a carbon-plated fiber fabric, or an aluminum foil fiber fabric. It should be understood that the conductive fabric is formed by using fiber cloth (generally polyester fiber cloth) as a base material and making the fiber cloth have metal conductive characteristics by electroplating a layer of metal coating. For example, the nickel-plated fiber cloth is formed by electroplating nickel on polyester fiber cloth to make the nickel-plated fiber cloth conductive.

In this embodiment of this application, a thicknesses of the first electrically conductive adhesion layer 304 and a thicknesses of the second electrically conductive adhesion layer 306 may be 2 µm to 20 µm. For example, the thickness of the first electrically conductive adhesion layer 304 and the thickness of the second electrically conductive adhesion layer 306 may be 10 µm, or may be 15 µm. The thickness of the first electrically conductive adhesion layer 304 and the thickness of the second electrically conductive adhesion layer 306 are set to be 2 µm to 20 µm, so that the first electrically conductive film 305 and the second electrically conductive film 307 are well connected to the foam core 301.

In this embodiment of this application, the first electrically conductive adhesion layer 304 and the second electrically conductive adhesion layer 306 are electrically conductive silver paste. For example, the electrically conductive silver paste may be disposed on the first electrically conductive film 305 and the second electrically conductive film 307, and the electrically conductive silver paste is bonded to the foam core 301 when the electrically conductive silver paste is not cured. In this way, the first electrically conductive adhesion layer 304, the second electrically conductive adhesion layer 306, the foam core 301, the first electrically conductive film 305, and the second electrically conductive film 307 form an overall structure. The electrically conductive silver paste ensures good bonding between the electrically conductive silver paste and the electrically conductive layer 308 of the foam core 301, and ensures conductive performance between the first electrically conductive film 305 and the foam core 301 and between the second electrically conductive film 307 and the foam core 301.

In this embodiment of this application, the porous foam body 302 is a low-density porous foam body 302 whose density is less than 200 kg/m³. For example, the density of the porous foam body 302 may be 150 kg/m³, or may be 100 kg/m³. The low-density porous foam body 302 can achieve 85% deformable amount, which significantly improves performance of the electrically conductive elastic connector 30.

A material of the porous foam body 302 may be at least one material of PU (ploy urethane, polyurethane), PP (Polypropylene, polypropylene), PE (polyethylene, polyethylene), PI (Polyimide, polyimide), silicone, polypropylene (polypropylene, PP), styrene-butadiene rubber, acrylate, vinyl acetate, vinylidene chloride, butyronitrile, silicone, acrylamide, natural rubber, polyvinyl chloride, polysulfide rubber, styrene-acrylate copolymer, vinyl acetate-acrylate copolymer, silicone-acrylate copolymer, modified silicone-acrylate copolymer, and rubber.

The porous foam body 302 may be of a three-dimensional mesh structure. FIG. 5 shows only a mesh connection of the porous foam body 302 on a two-dimensional plane, and a mesh shape is an example.

The porous foam body 302 may have an inner hole and an outer hole. The inner hole is located at the interior of the porous foam body 302, and the outer hole is located on the outer surface of a structure of the foam body 302. The inner hole may be disposed to support the foam core 301.

The outer hole is disposed, and the plurality of electrically conductive layers may be disposed on a hole wall of the outer hole, to ensure conductive performance of the outer surface of the foam core 301, and implement conduction of the first electrically conductive film 305 and the second electrically conductive film 307.

It may be understood that the outer hole is a hole visible on the outer surface of the foam core 301, and the inner hole may or may not communicate with the outer hole or the outer surface of the foam core 301.

The inner hole and the outer hole may be formed through foaming. It should be understood that the inner hole and the outer hole are merely example names, and do not represent a limitation on a size, a shape, and the like of a hole opened on the foam body 302.

FIG. 6 is an electron microscope photo of an electrically conductive layer on a porous foam body in an electrically conductive elastic connector according to an embodiment of this application.

A plurality of electrically conductive layers are attached to hole walls of an inner hole and an outer hole of a porous foam body. FIG. 6 shows an electron microscope photo of an electrically conductive layer 308. With reference to FIG. 6, the electrically conductive layer 308 is formed by attaching nanowires to the porous foam body. The electrically conductive layer is a nanowire layer of a multi-layer structure, can implement high conductive performance, and has a high bonding force with the porous foam body 302, so that conductivity is improved and a risk such as a short circuit caused by a problem such as a breaking or fall-off of the electrically conductive layer is avoided.

In this embodiment of this application, the inner hole includes at least one of a closed hole and an open hole. For example, the inner hole may be a closed hole or an open hole, or the inner hole includes two types of holes: a closed hole and an open hole. When the inner hole is an open hole, the inner hole may be connected to an outer hole to form an open hole, or may be connected to an outer surface of the foam core 301 to be used as an outer hole.

The structure of the electrically conductive elastic connector 30 includes both an open hole and a closed hole. In addition to rigidity and stability, a position or a region of the open hole is adjusted, so that the electrically conductive elastic connector may also have a soft and bendable characteristic.

In this embodiment of this application, a diameter of a hole of the porous foam body 302 is 30 µm to 500 µm. For example, the diameter of the hole of the porous foam body 302 may be 100 µm, or may be 300 µm. Diameters of the holes of the porous foam body 302 may be the same or may be different. In this way, compressible space and a rebound force of the porous foam body 302 can meet a requirement of the operating range after the nanowire is attached to the hole wall.

In this embodiment of this application, a diameter of the nanowire is 10 nm to 50 nm. For example, the diameter of the nanowire may be 30 nm, or may be 40 nm. The diameter of the nanowire coated on the hole wall is controlled to be between 10 nm and 100 nm, so that the nanowire can be more firmly coated on the hole wall of the inner hole, to avoid generation of high harmonics caused by fall-off of the nanowires under pressure. In addition, low ground impedance may be obtained by setting a diameter range from 10 nm to 50 nm.

The nanowire may include but is not limited to at least one of a carbon nanotube, a tin nanowire, a copper nanowire, nano-nickel, nano-silver, and a gold nanowire. The nanowire may be attached to the hole wall of the inner hole through coating or drip coating. In this embodiment of this application, an example in which the nanowire is coated on the inner hole is used for description.

In some embodiments, a ratio of a length of the nanowire to a diameter of the nanowire ranges from 1000: 1 to 5000: 1.

The ratio of the length of the nanowire to the diameter of the nanowire ranges from 1000:1 to 5000:1, so that the nanowire may be prevented from being broken when the electrically conductive elastic connector is under pressure, and the nanowire has rigidity and stability.

In some embodiments, to enhance conductivity, prevent the nanowire from falling off due to pressure on the foam body 302, and avoid generation of a high harmonic, a diameter of the nanowire is approximately 70 nm. It should be understood that, in an actual processing process, a diameter of a nanowire and a ratio of a length to a diameter of an actual product may deviate, provided that the deviation is within an allowed error range.

It is clearly that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. An electrically conductive elastic connector, wherein the electrically conductive elastic connector is configured to connect a first element and a second element, and the electrically conductive elastic connector comprises:
a foam core, wherein the foam core comprises a porous foam body and an electrically conductive layer located on the porous foam body, the electrically conductive layer is an electrically conductive layer formed by attaching nanowires to an interior and an outer surface of the porous foam body, and the foam core has a first surface and a second surface that are disposed opposite to each other;
a first electrically conductive adhesion layer, wherein the first electrically conductive adhesion layer is located on the first surface of the foam core;
a second electrically conductive adhesion layer, wherein the second electrically conductive adhesion layer is located on the second surface of the foam core;
a first electrically conductive film, wherein the first electrically conductive film is stacked on the first electrically conductive adhesion layer, and the first electrically conductive film is configured to electrically connect to the first element; and
a second electrically conductive film, wherein the second electrically conductive film is stacked on the second electrically conductive adhesion layer, and the second electrically conductive film is configured to electrically connect to the second element.

2. The electrically conductive elastic connector according to claim 1, wherein a thickness of the first electrically conductive film and a thickness of the second electrically conductive film are 0.01 mm to 0.1 mm.

3. The electrically conductive elastic connector according to claim 1, wherein the first electrically conductive film and the second electrically conductive film are conductive fabrics or copper foils.

4. The electrically conductive elastic connector according to any one of claims 1 to 3, wherein a thickness of the first electrically conductive adhesion layer and a thickness of the second electrically conductive adhesion layer are 2 µm to 20 µm.

5. The electrically conductive elastic connector according to any one of claims 1 to 3, wherein the first electrically conductive adhesion layer and the second electrically conductive adhesion layer are electrically conductive silver paste.

6. The electrically conductive elastic connector according to any one of claims 1 to 3, wherein the porous foam body is a low-density porous foam body whose density is less than 200 kg/m³.

7. The electrically conductive elastic connector according to any one of claims 1 to 3, wherein the porous foam body has an inner hole and an outer hole, and a plurality of electrically conductive layers are attached to a hole wall of the inner hole and a hole wall of the outer hole; and
the inner hole is located at the interior of the porous foam body, and the outer hole is located on the outer surface of the foam body structure.

8. The electrically conductive elastic connector according to claim 7, wherein the inner hole comprises at least one of a closed hole and an open hole.

9. The electrically conductive elastic connector according to any one of claims 1 to 3, wherein a diameter of a hole of the porous foam body is 30 µm to 500 µm.

10. The electrically conductive elastic connector according to any one of claims 1 to 3, wherein a diameter of the nanowire is 10 nm to 50 nm.

11. The electrically conductive elastic connector according to any one of claims 1 to 3, wherein a ratio of a length of the nanowire to a diameter of the nanowire ranges from 1000:1 to 5000:1.

12. The electrically conductive elastic connector according to any one of claims 1 to 3, wherein the nanowire is at least one of nano-silver, nano-copper, a carbon nanowire, and nano-gold.

13. The electrically conductive elastic connector according to any one of claims 1 to 3, wherein the porous foam body is of a three-dimensional mesh structure, and the mesh structure is attached with a plurality of electrically conductive layers.

14. An electronic device, wherein the electronic device comprises a first element, a second element, and the electrically conductive elastic connector according to any one of claims 1 to 13; and
the first electrically conductive film of the electrically conductive elastic connector is electrically connected to the first element, and the second electrically conductive film of the electrically conductive elastic connector is electrically connected to the second element.

15. The electronic device according to claim 14, wherein the electronic device further comprises a conductive adhesive, the conductive adhesive is disposed between the first electrically conductive film and the first element, and the conductive adhesive is disposed between the second electrically conductive film and the second element.

16. The electronic device according to claim 14, wherein the first element is a middle frame, and the second element is at least one of an antenna bracket, a display module, a shielding cover, or a camera module.
